# EUROPÄISCHE PATENTSCHRIFT

(11) **EP 2 271 785 B1**
(45) Veröffentlichungstag und Bekanntmachung des Hinweises auf die Patenterteilung: **11.04.2018**
(21) Anmeldenummer: 09735341.1
(22) Anmeldetag: 18.04.2009
(51) Int. Cl.: C23C 14/06, C23C 14/02, C23C 28/04, F01D 5/28

(54) **EROSIONSSCHUTZBESCHICHTUNG**
EROSION PROTECTION COATING
REVÊTEMENT DE PROTECTION CONTRE L'ÉROSION

(30) Priorität: 21.04.2008 DE 102008019891
(43) Veröffentlichungstag der Anmeldung: 12.01.2011
(73) Patentinhaber: MTU Aero Engines AG, 80995 München (DE)
(72) Erfinder: HEUTLING, Falko, 81377 München (DE); UIHLEIN, Thomas, 85221 Dachau (DE); EICHMANN, Wolfgang, 82178 Puchheim (DE)
(86) Internationale Anmeldenummer: PCT/DE2009/000533
(87) Internationale Veröffentlichungsnummer: WO 2009/129790

(56) Entgegenhaltungen:
- WO-A-2005/066384
- WO-A-2008/042391
- WO-A-2008/119173
- WO-A-2009/026677
- DE-T5-112006 003 471
- JP-A- 2006 037 212
- US-A1- 2009 011 195
- OKUMIYA M ET AL: "Mechanical properties and tribological behavior of TiN-CrAlN and CrN-CrAlN multilayer coatings" SURFACE AND COATINGS TECHNOLOGY ELSEVIER SWITZERLAND, Bd. 112, Nr. 1-3, Februar 1999 (1999-02), Seiten 123-128, XP002540894 ISSN: 0257-8972
- BARSHILIA ET AL: "Nanolayered multilayer coatings of CrN/CrAlN prepared by reactive DC magnetron sputtering" APPLIED SURFACE SCIENCE, ELSEVIER, AMSTERDAM, NL, Bd. 253, Nr. 11, 2. März 2007 (2007-03-02), Seiten 5076-5083, XP005911102 ISSN: 0169-4332

## Beschreibung

Die Erfindung betrifft eine Erosionsschutzbeschichtung, insbesondere für Gasturbinenbauteile, nach dem Oberbegriff des Anspruchs 1. Weiterhin betrifft die Erfindung ein Gasturbinenbauteil mit einer Erosionsschutzbeschichtung nach dem Oberbegriff des Anspruchs 5.
Aus dem Stand der Technik ist es bekannt, Gasturbinenbauteile zum Schutz derselben gegenüber Erosion an Oberflächen mit einer als Erosionsschutzbeschichtung ausgebildeten Verschleißschutzbeschichtung zu versehen. So sind aus dem Stand der Technik Erosionsschutzbeschichtungen mit einem horizontal segmentierten bzw. einem mehrschichtigen oder mehrlagigen Aufbau bekannt, die mindestens eine relativ harte, keramische Schicht und mindestens eine relativ weiche, metallische Schicht umfassen. Die keramischen Schichten sowie die metallischen Schichten solcher mehrschichtigen bzw. horizontal segmentierten Erosionsschutzbeschichtungen sind wechselweise übereinander angeordnet, und zwar derart, dass eine außenliegende Schicht, die eine äußere Oberfläche der Erosionsschutzbeschichtung bildet, als keramische Schicht ausgebildet ist. Solche mehrschichtigen bzw. horizontal segmentierten Erosionsschutzbeschichtungen werden auch als Multilayer-Beschichtungen bezeichnet.

Die Druckschrift DE 11 2006 003 471 T5 offenbart eine solche Erosionschutzbeschichtung.

Derartige aus dem Stand der Technik bekannte Erosionsschutzbeschichtungen, die aus alternierenden metallischen und keramischen Lagen bzw. Schichten aufgebaut sind, verfügen insbesondere bei Betriebstemperaturen zwischen 500°C und 700°C, insbesondere bei in etwa 600°C und bei kleinen Einfallswinkeln der Erosionspartikel, über eine reduzierte Erosionsschutzwirkung. Es besteht daher ein Bedarf an Erosionsschutzbeschichtungen, die auch dann, wenn die Bauteile mit den Erosionsschutzbeschichtungen solchen Betriebsbedigungen ausgesetzt sind, wie dies insbesondere bei Gasturbinenbauteilen der Fall ist, eine gute Erosionsschutzwirkung gewährleisten.
Hiervon ausgehend liegt der vorliegenden Erfindung das Problem zu Grunde, eine neuartige Erosionsschutzbeschichtung zu schaffen.

Dieses Problem wird durch eine Erosionsschutzbeschichtung im Sinne von Anspruch 1 gelöst.

Erfindungsgemäß ist die oder jede harte Schicht sowie die oder jede weiche Schicht der Erosionsschutzbeschichtung jeweils als keramische Schicht ausgebildet.
Die hier vorliegende Erfindung schlägt eine Erosionsschutzbeschichtung vor, die aus alternierenden weichen und harten Lagen bzw. Schichten ausgebildet ist, wobei sowohl die oder jede harte Schicht als auch die oder jede weiche Schicht der Erosionsschutzbeschichtung als keramische Schicht ausgebildet ist. Die Erosionsschutzbeschichtung im Sinne der Erfindung ist demnach als rein keramische Multilayer-Erosionsschutzbeschichtung ausgebildet.
Der Erfindung liegt die Erkenntnis zugrunde, dass die bei aus dem Stand der Technik üblichen metallischen Schichten bzw. Lagen einer Erosionsschutzbeschichtung bei Betriebstemperaturen zwischen 500°C und 700°C, insbesondere bei in etwa 600°C, durch Interdiffusion und/oder Sprödphasenbildung eine negative Veränderung der physikalischen und mechanischen Eigenschaften der Erosionsschutzbeschichtung und damit einhergehend eine Reduzierung der Erosionsschutzwirkung verursachen.
Bevorzugte Weiterbildungen der Erfindung ergeben sich aus den Unteransprüchen und der nachfolgenden Beschreibung. Ausführungsbeispiele der Erfindung werden, ohne hierauf beschränkt zu sein, an Hand der Zeichnung näher erläutert. Dabei zeigt:
- Fig. 1:: einen schematisierten Querschnitt durch ein erfindungsgemäßes Gasturbinenbauteil mit einer erfindungsgemäßen Erosionsschutzbeschichtung;
- Fig. 2:: ein Detail der Erosionsschutzbeschichtung gemäß Fig. 1; und
- Fig. 3:: ein alternatives Detail der Erosionsschutzbeschichtung gemäß Fig. 1.

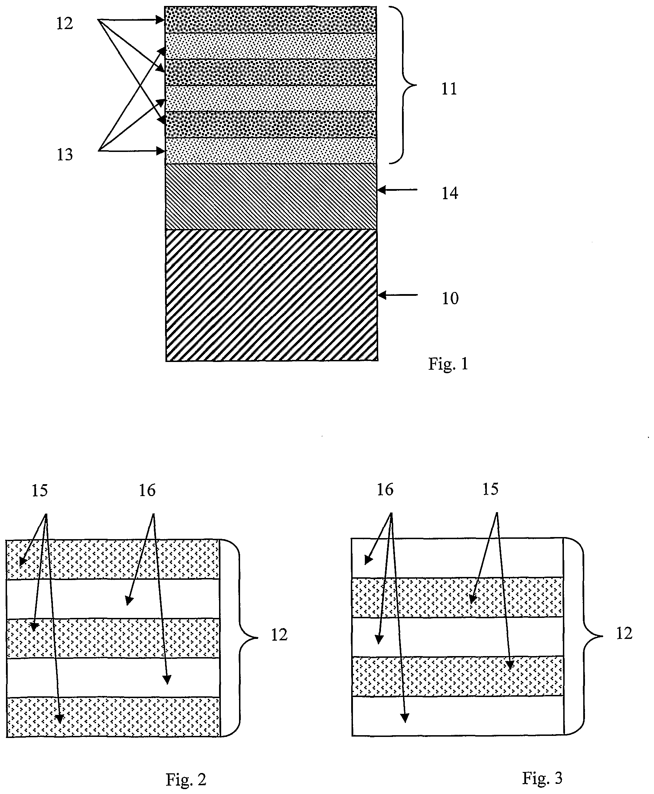

Die hier vorliegende Erfindung betrifft eine Erosionsschutzbeschichtung, insbesondere eine Erosionsschutzbeschichtung für Gasturbinenbauteile. Die Erfindung wird nachfolgend unter Bezugnahme auf Fig. 1 im Detail beschrieben.
So zeigt Fig. 1 stark schematisiert einen Querschnitt durch ein Gasturbinenbauteil 10, wobei auf das Gasturbinenbauteil 10 eine erfindungsgemäße Erosionsschutzbeschichtung 11 aufgebracht ist. Die erfindungsgemäße Erosionsschutzbeschichtung 11 verfügt über einen horizontal segmentierten bzw. mehrschichtigen Aufbau, nämlich derart, dass alternierend harte Schichten 12 und weiche Schichten 13 auf das Gasturbinenbauteil 10 aufgebracht sind.

Die harten Schichten 12 und die weichen Schichten 13 sind dabei derart wechselweise übereinander angeordnet, dass eine außenliegende Schicht, die eine äußere Oberfläche der Erosionsschutzbeschichtung 11 bildet, als relativ harte Schicht 12 ausgebildet ist.

Die aus mehreren alternierend aufgebrachten harten Schichten 12 und weichen Schichten 13 zusammengesetzte Erosionsschutzbeschichtung 11 ist als Multilayer-Erosionsschutzbeschichtung ausgeführt.

Im Sinne der hier vorliegenden Erfindung sind sowohl die harten Schichten 12 als auch die weichen Schichten 13 der Erosionsschutzbeschichtung 11 als keramische Schichten ausgebildet.

Die harten Schichten 12 sind dabei als CrAlN-Schichtenund die weichen Schichten 13 als CrN-Schichten ausgebildet.

Die Schichtdicke der harten, keramischen Schichten 12 liegt dabei in einer Größenordnung zwischen 0,5 µm und 10 µm, vorzugsweise bei 3 µm. Die Schichtdicke der weichen, keramischen Schichten 13 liegt in einer Größenordnung zwischen 0,5 µm und 5 µm, vorzugsweise bei 1 µm. Die Schichten 12, 13 der Erosionsschutzbeschichtung 11 werden vorzugsweise mit Hilfe eines PVD-Verfahrens auf das Gasturbinenbauteil 10 aufgebracht.

Fig. 2 und 3 zeigen bevorzugte Ausgestaltungen der harten Schichten 12, die gemäß Fig. 2 und 3 ihrerseits als Multilayer-Schichten aus den Schichten 15 und 16 aufgebaut sind, wobei es sich bei den Schichten 15 um CrAlN-Schichten und bei den Schichten 16 um CrN-Schichten handelt.

Die Schichtdicke der einzelnen Schichten 15, 16 der harten Schichten 12 liegt dabei in einer Größenordnung zwischen 10 nm und 200 nm, vorzugsweise in einer Größenordnung zwischen 40 nm und 200 nm.

Die harten Schichten 12 sind demnach gemäß Fig. 2 und 3 als nanostrukturierte Multilayer-Schichten ausgeführt. Die nanostrukturierten Schichten 15, 16 der harten Schichten 12 werden vorzugsweise mit Hilfe eines PVD-Verfahrens aufgebracht.
Wie Fig. 2 und 3 entnommen werden kann, ist die Reihenfolge der Schichten 15, 16 innerhalb der harten Schichten 12 frei wählbar.

Auch ist die Anzahl und damit Periodizität der Schichten 15, 16 innerhalb der harten Schichten 12 frei wählbar.
Im bevorzugten Ausführungsbeispiel der Fig. 1 ist die erfindungsgemäße Erosionsschutzbeschichtung 11 unter Zwischenanordnung einer Haftvermittlungsschicht 14 auf die Oberfläche des Gasturbinenbauteils 10 aufgebracht. Die Haftvermittlungsschicht 14 ist vorzugsweise ebenfalls keramisch ausgebildet, nämlich aus einem relativ duktilen keramischen Werkstoff mit einer geringen Eigenspannung, vorzugsweise aus gradierten CrN.
Die als gradierten CrN-Schicht ausgebildete Haftvermittlungsschicht 14 ist dabei weicher und duktiler als die oder jede als CrN-Schicht ausgebildete, weiche Schicht 13 der Erosionsschutzbeschichtung 11.

Vorzugsweise beträgt die Dicke der Haftvermittlungsschicht 14 zwischen 0,01 µm und 0,5 µm, insbesondere 0,1 µm.

## Patentansprüche

1. Erosionsschutzbeschichtung, insbesondere für Gasturbinenbauteile, mit einem horizontal segmentierten bzw. mehrschichtigen Aufbau, nämlich mit mindestens einer harten Schicht (12) und mit mindestens einer weichen Schicht (13), wobei die oder jede harte Schicht sowie die oder jede weiche Schicht wechselweise derart übereinander angeordnet sind, dass eine außenliegende Schicht, die eine äußere Oberfläche der Erosionsschutzbeschichtung bildet, als harte Schicht (12) ausgebildet ist, wobei die oderjede harte Schicht (12) sowie die oder jede weiche Schicht (13) jeweils als keramische Schichten ausgebildet sind, **dadurch gekennzeichnet, dass** die oder jede harte Schicht (12) wechselweise übereinander angeordnete CrAlN-Schichten (15) und CrN-Schichten (16) aufweist, die jeweils eine Dicke zwischen 10 nm und 200 nm aufweise, derart, dass die oder jede harte Schicht (12) nanostrukturiert ist.

2. Erosionsschutzbeschichtung nach Anspruch 1,
**dadurch gekennzeichnet, dass**
die oder jede harte Schicht (12) eine Dicke zwischen 0,5 µm und 10 µm aufweist.

3. Erosionsschutzbeschichtung nach einem der Ansprüche 1 bis 2,
**dadurch gekennzeichnet, dass**
die oder jede weiche Schicht (13) eine CrN-Schicht ist.

4. Erosionsschutzbeschichtung nach einem der Ansprüche 1 bis 3,
**dadurch gekennzeichnet, dass**
die oder jede weiche Schicht (13)eine Dicke zwischen 0,5 µm und 5 µm aufweist.

5. Gasturbinenbauteil mit einer auf eine Oberfläche desselben aufgebrachten Erosionsschutzbeschichtung,
**dadurch gekennzeichnet, dass**
die Erosionsschutzbeschichtung (11) nach einem der Ansprüche 1 bis 4 ausgebildet ist.

6. Gasturbinenbauteil nach Anspruch 5,
**dadurch gekennzeichnet, dass**
die Erosionsschutzbeschichtung (11) unter Zwischenanordnung einer Haftvermittlungsschicht (14) auf die Oberfläche des Gasturbinenbauteils aufgebracht ist.

7. Gasturbinenbauteil nach Anspruch 5 oder 6,
**dadurch gekennzeichnet, dass**
die Haftvermittlungsschicht (14) eine Dicke zwischen 0,01 µm und 0,5 µm ausweist.

8. Gasturbinenbauteil nach einem der Ansprüche 5 bis 7,
**dadurch gekennzeichnet, dass**
die Haftvermittlungsschicht (14) duktil mit einer geringen Eigenspannung ausgebildet ist.

9. Gasturbinenbauteil nach einem der Ansprüche 5 bis 8,
**dadurch gekennzeichnet, dass**
die Haftvermittlungsschicht (14) eine gradierte CrN-Schicht ist, die weicher und duktiler ist als die oder jede als CrN-Schicht ausgebildete, weiche Schicht (13) der Erosionsschutzbeschichtung (11).

## Claims

1. An erosion protection coating, in particular for gas turbine components, having a horizontally segmented or multi-layered construction, namely, having at least one hard layer (12) and having at least one soft layer (13), wherein the or each hard layer as well as the or each soft layer are situated one on top of the other in alternation, in such a way that an outer layer, which forms an outer surface of the erosion protection coating, is formed as a hard layer (12), wherein the or each hard layer (12) as well as the or each soft layer (13) are formed as ceramic layers in each case, **characterized in that** the or each hard layer (12) has CrAlN layers (15) and CrN layers (16) situated one on top of the other in alternation, each having a thickness between 10 nm and 200 nm, in such a way that the or each hard layer (12) is nanostructured.

2. The erosion protection coating according to Claim 1,
**characterized in that**
the or each hard layer (12) has a thickness between 0.5 µm and 10 µm.

3. The erosion protection coating according to any one of Claims 1 to 2,
**characterized in that**
the or each soft layer (13) is a CrN layer.

4. The erosion protection coating according to any one of Claims 1 to 3,
**characterized in that**
the or each soft layer (13) has a thickness between 0.5 µm and 5 µm.

5. A gas turbine component having an erosion protection coating applied to a surface thereof,
**characterized in that**
the erosion protection coating (11) is formed according to any one of Claims 1 to 4.

6. The gas turbine component according to Claim 5,
**characterized in that**
the erosion protection coating (11) is applied to the surface of the gas turbine component, with a bonding layer (14) situated in between.

7. The gas turbine component according to Claim 5 or 6,
**characterized in that**
the bonding layer (14) has a thickness between 0.01 µm and 0.5 µm.

8. The gas turbine component according to any one of Claims 5 to 7,
**characterized in that**
the bonding layer (14) has a ductile design with a low internal stress.

9. The gas turbine component according to any one of Claims 5 to 8,
**characterized in that**
the bonding layer (14) is a graded CrN layer that is softer and more ductile than the or each soft layer (13) of the erosion protection coating (11) formed as a CrN layer.

## Revendications

1. Revêtement de protection contre l'érosion, destiné en particulier à des composants de turbine à gaz, comprenant une structure multicouche ou segmentée horizontalement, à savoir au moins une couche dure (12) et au moins une couche souple (13), la ou chaque couche dure et la ou chaque couche souple étant disposées alternativement les unes au-dessus des autres de telle sorte qu'une couche extérieure, qui forme une surface extérieure du revêtement de protection contre l'érosion, soit conçue comme une couche dure (12), la ou chaque couche dure (12) et la ou chaque couche souple (13) étant chacune conçues comme une couche céramique, **caractérisé en ce que** la ou chaque couche dure (12) comporte des couches de CrAlN (15) et des couches de CrN (16) qui sont disposées alternativement les unes au-dessus des autres et qui ont chacune une épaisseur comprise entre 10 nm et 200 nm de sorte que la ou chaque couche dure (12) soit nanostructurée.

2. Revêtement de protection contre l'érosion selon la revendication 1,
**caractérisé en ce que**
la ou chaque couche dure (12) a une épaisseur comprise entre 0,5 µm et 10 µm.

3. Revêtement de protection contre l'érosion selon l'une des revendications 1 à 2,
**caractérisé en ce que**
la ou chaque couche souple (13) est une couche de CrN.

4. Revêtement de protection contre l'érosion selon l'une des revendications 1 à 3,
**caractérisé en ce que**
la ou chaque couche molle (13) a une épaisseur comprise entre 0,5 µm et 5 µm.

5. Composant de turbine à gaz pourvu d'un revêtement de protection contre l'érosion appliqué sur une surface de celui-ci,
**caractérisé en ce que**
le revêtement de protection contre l'érosion (11) est conçu selon l'une des revendications 1 à 4.

6. Composant de turbine à gaz selon la revendication 5,
**caractérisé en ce que**
le revêtement de protection contre l'érosion (11) est appliqué sur la surface du composant de turbine à gaz avec interposition d'une couche (14) favorisant l'adhérence.

7. Composant de turbine à gaz selon la revendication 5 ou 6,
**caractérisé en ce que**
la couche (14) favorisant l'adhérence a une épaisseur comprise entre 0,01 µm et 0,5 µm.

8. Composant de turbine à gaz selon l'une des revendications 5 à 7,
**caractérisé en ce que**
la couche (14) favorisant l'adhérence est ductile avec une faible contrainte interne.

9. Composant de turbine à gaz selon l'une des revendications 5 à 8,
**caractérisé en ce que**
la couche (14) favorisant l'adhérence est une couche de CrN à gradation qui est plus molle et plus ductile que la ou chaque couche souple (13), conçue comme une couche de CrN, du revêtement de protection contre l'érosion (11).
